# EUROPEAN PATENT APPLICATION

(11) **EP 3 907 584 A1**
(43) Date of publication of application: **10.11.2021**
(21) Application number: 20172951.4
(22) Date of filing: 05.05.2020
(51) Int. Cl.: G06F 1/20, H01L 23/473

(54) **ADAPTED COLD PLATE ASSEMBLY**

(71) Applicant: Asetek Danmark A/S, 9220 Aalborg Ost (DK)
(72) Inventor: Fuglsang, Lars Brinkmann, 9000 Aalborg (DK)
(74) Representative: Budde Schou A/S

(57) **Abstract**

There is an increased need for more granularly controlled heat exchange and adapted cooling for computing devices. This is solved by providing a cold plate assembly for liquid-cooling a computing device, said cold plate assembly comprising:
- a cold plate with an exterior surface (111) for facing the computing device to be cooled and an opposite inner surface with fins and microchannels between said fins,
- a distribution block fastened to said cold plate and together with said cold plate forming a chamber surrounding the fins between the distribution block and the inner surface of said cold plate, said distribution block comprising
- an inlet opening for receiving cooling liquid from said liquid cooling system, the inlet opening connected to at least two inlet slots extending over the fins and angled relative to the fins and for transporting liquid along said inlet slots and down towards said inner surface of said cold plate via said microchannels and
- an outlet opening for dispensing cooling liquid to said liquid cooling system, the outlet opening connected to at least two outlet slots extending over the fins and angled relative to the fins and for transporting liquid from said inner surface of said cold plate via said microchannels and along said outlet slots to said outlet opening.

## Description

### FIELD OF THE INVENTION

The invention relates to a cold plate assembly for receiving heat from electronic devices, e.g. liquid cooling systems having such cold plate assembly, and manufacture of such cold plate assembly.

### BACKGROUND OF THE INVENTION

Removing heat generated by electronic components is of paramount importance with ever increasing power density of modern computing systems. There is a tendency towards an increase in the number of cores of modern primary heat sources such as central processing units (CPU) and graphics processing units (GPU). Such multi-core units have large footprints and dispersed heat generation. Active cooling is used for primary heat sources to avoid thermal throttling, and a prevalent method is liquid cooling.

For secondary heat sources, passive cooling is used, such as aluminium heat sinks, whose size depends on power density. As power density increases further, passive cooling may become disadvantageous. An example component is a high-powered random-access memory (RAM) module which may throttle a system thermally or require a heat sink being considerably larger and thereby compromising power density. Actively cooling secondary heat sources has become more prevalent and can be done in a few ways.

Secondary heat sources may be air-cooled. However, geometry and arrangement of heat sinks may constrict or direct air flow in a way that reduces the efficiency of such a solution further. Optimal fan placement becomes difficult.

Another way is to use liquid cooling. However, for non-standardized components such as power supply units (PSU), or for small parts, it may be prohibitively expensive to develop liquid cooling parts as such liquid cooling parts may be so large as to compromise power density. Even further, the more components are liquid-cooled, the more airflow is constricted and hampered for the rest of the secondary components.

Thus, there is a need for solutions to cool various components of a computing system accurately, while retaining a small footprint.

### SUMMARY OF THE INVENTION

In an aspect of the invention, there is provided a cold plate assembly for use in a liquid cooling system for cooling a computing device, said cold plate assembly comprising:
- a cold plate with an exterior surface for facing the computing device to be cooled and an opposite inner surface with fins and microchannels between said fins,
- a distribution block fastened to said cold plate and together with said cold plate forming a chamber surrounding the fins between the distribution block and the inner surface of said cold plate, said distribution block comprising
- an inlet opening for receiving cooling liquid from said liquid cooling system, the inlet opening connected to at least two inlet slots extending over the fins and angled relative to the fins and for transporting liquid along said inlet slots and down towards said inner surface of said cold plate via said microchannels and
- an outlet opening for dispensing cooling liquid to said liquid cooling system, the outlet opening connected to at least two outlet slots extending over the fins and angled relative to the fins and for transporting liquid from said inner surface of said cold plate via said microchannels and along said outlet slots to said outlet opening.

By providing a chamber and inlet slots and outlet slots inside the chamber, a given chamber footprint can provide a variety of different cooling profiles depending on arrangement and parameters of the inlets, outlets, fins, inlet manifold and outlet manifold relatively independently from other constructional interests such as fastening and physical adaptations to the elements of the electronic part to be cooled. Thereby, it becomes possible to map the effected cooling accurately to the expected/simulated or real-life heat production of the electrical component.

The slots are formed in a slot layer which directs the liquid to and from the microchannels and which is located on top of part of the fins. In other words, the slot layer is either located on top of the fins or is formed integrally with the fins.

The slots extend angled to the extension of the fins, preferably perpendicular to the fins. Preferably, each slot allows liquid to travel to each of the microchannels and at least allows liquid to travel to substantially all of the microchannels.

Such mutually adapted slots can be produced by either providing recessed channels in the distribution block, by providing recessed channels in the fins, by providing a slot layer formed as an individual part having such a structure as to form the slots between the distribution block and the cold plate, or a combination of any of these.

The liquid path of the cold plate assembly of the invention can be adapted in a plurality of ways:
- relative widths of a subset of inlet/outlet slots among inlet/outlet slots,
- relative spacing of inlet/out slots to effect different path lengths in the chamber,
- constrictions in the chamber that force the liquid to near the horizontal part of the inner surface of the cold plate, and
- fin height beneath slots.

By inlet slots and outlet slots are meant elongate inlets and outlets that extend angled to the fins.

In an embodiment, the fins are arranged in a first direction, and where said inlet slots and outlet slots are elongated in a second direction being orthogonal to the first direction, and where said inlet slots interdigitate with said outlet slots. Thereby, a compact cold plate assembly is achieved that has a low overall constriction while facilitating high thermal exchange. By interdigitate is meant that the slots are arranged alternating.

In an embodiment, the cold plate assembly has been specifically adapted to a predefined cooling profile of the computing device by the distribution block having a slot layer with an adapted slot architecture, said slot architecture relating to the horizontal layout of the slots over the fins and the vertical layout of the slots towards the cold plate inner surface, where the adaptation comprises at least two inlet slots or two outlet slots having dissimilar geometries.

By slot architecture is meant the horizontal layout of the slots and the vertical layout of the slots. The horizontal layout of the slots covers the number of slots, the sizes of individual slots and the arrangement of the slots over the footprint of the slotted area which corresponds substantially to a finned area beneath. The vertical layout of the slots relates to how far down into the fins the individual slots extend. Traditionally, all slots extend equally far which is by abutting onto the fins. However, the inventor has realised that having certain slots with groves, which extend beneath the top of the fins, achieves a benefit of increased liquid speed at the location while retaining a high fin height in other places for improved heat exchange.

In an embodiment, the cold plate assembly comprises a separate slot layer sandwiched between the cold plate and the housing block, said slot layer separating inlet slots from outlet slots.

By using a separate part as a slot layer, a constructionally simple system is achieved. It may be useful to use gasket parts or seals inside to improve the seal between the parts further.

In an embodiment, the cold plate assembly comprises a slot layer having an elastic seal component deformable to the dimensions of the cold plate and the distribution block. The separate slot layer may thus be formed in a compressible material or be formed partly in a compressible material.

Manifold, when used alone, denotes the traditional terms of either a combination or a distributing manifold. The term manifold structure is used to denote a combination of manifolds forming general distributing-collecting systems of manifolds in the cold plate assembly. The cold plate assembly liquid path achieves such distributing-combining manifold structure. This manifold structure can encompass any types of manifold structure, such as a U-type structure, an I-type structure, a Z-type structure or a branching/capillary type of manifold structure.

The liquid channel including the inlet slots, the chamber and the outlet slots forms an inner manifold structure. The inner manifold structure can be any type of manifold structure as described above. The inner manifold structure is preferably a variation of a Z-type manifold structure. Thereby, improved space utilisation and flow distribution is achieved, since an inlet manifold is provided on one side, and the outlet manifold is provided opposite.

In an embodiment, the inner manifold structure distributes pressure among flow paths inside the chamber, i.e. between fins, in a substantially evenly manner. In an embodiment, the manifold structure distributes flow among flow paths inside the chamber in a substantially evenly manner.

In an embodiment, the path going from the inlet region to inlet slots to the microchannels to the outlet slots and to the outlet region forms a Z-type manifold structure. This can be seen as an inner manifold structure of the cold plate assembly. In an embodiment, the inner manifold structure has a combined I-type manifold structure, a Z-type manifold structure, or a branching manifold structure.

The inlet manifold and the outlet manifold, when viewed with this inner manifold structure, form an enveloping manifold structure, where the inlet slots and outlet slots are the channels of the enveloping manifold. The enveloping manifold can be any type of manifold structure as described above. Preferably, the enveloping manifold structure forms an I-type manifold structure, whereby the arrangement and relative widths of the inlet slots and outlet slots can be controlled thus controlling flow distribution.

In an embodiment, the cold plate assembly has a slot layer with an inlet region and an outlet region and the inlet slots and the outlet slots, and where the inlet slots and outlet slots interdigitate with each other at an angle relative to the fins, preferably orthogonally, whereby the inlet region forms a dividing I-type manifold structure, and the outlet region forms a collecting I-type manifold.

The distribution block and the cold plate, when attached, form a chamber around the fins. The chamber also surrounds the inlet slots and outlet slots. The part of the chamber comprising the slots will be referred to in some places as the slot layer, and as will be clear later, it can be formed in the distribution block as a separate unit or as part of the fins.

In an embodiment, the distribution block or the cold plate assembly comprises a slot layer having a slot architecture describing the number of slots and relative size and arrangement of said slots, and a vertical layout describing the relative slot depths facing towards the cold plate inner surface, where the cold plate assembly is adapted by the slot layer having at least one of the following:
- at least two inlet slots with dissimilar widths,
- at least two outlet slots with dissimilar widths,
- at least one, preferably at least two slots whose neighbouring slots are spaced therefrom dissimilarly, measured as the span between adjacent slot edges, and
- a slot comprising a recessed groove in the fins, the fin height beneath said slot being lower than the fin height beneath another slot.

Other embodiments relate to each of these variations individually.

In an embodiment, the slot layer has at least two inlet slots with dissimilar widths.

In an embodiment, the slot layer has at least two outlet slots with dissimilar widths.

In an embodiment, the inlet slot openings and outlet slot openings are generally rectangular in shape. Thereby, they are easy to produce and present relatively few variations during simulation.

In an embodiment, at least one inlet slot opening and at least one outlet slot opening are generally trapezoid in shape. Thereby, the inlet end of the inlet slots are wider than the furthest end, while the outlet end of the outlet slots are wider than the furthest end, allowing a higher general flowrate. In an embodiment, at least two trapezoid-shaped slots have angled sides that are not parallel. Thereby, liquid flow through the cold plate assembly is further adapted.

In an embodiment, the slot layer has at least one, preferably at least two slots, whose neighbouring slots are spaced therefrom dissimilarly, measured as the span between adjacent slot edges.

In an embodiment, the distances between neighbouring inlet slots and outlet slots are dissimilar, whereby the effected thermal work varies among sections of the cold plate exterior surface, when a liquid pass through said cold plate assembly. This allows a differentiated heat transfer over the outer surface of the cold plate, allowing improved localised cooling in certain areas while retaining a low pump pressure and power usage.

In an embodiment, the liquid paths through the cold plate assembly are dimensioned in a manner that effects a non-uniform cooling over the cold plate exterior surface.

In an embodiment, the slots are placed asymmetrically. Thereby, even more differentiated heat transfer over the outer surface of the cold plate is allowed. In an embodiment, the liquid paths through the cold plate assembly are dimensioned in a manner that effects an asymmetrical cooling over the cold plate exterior surface.

In an embodiment, the slot layer has a slot comprising a recessed groove (251, 951) in the fins, the fin height beneath said slot (943J) being lower than the fin height beneath another slot (943K).

In an embodiment, the fins have grooves perpendicular to their extension. These may be milled out. By inserting constrictions into these grooves from above, flow is constricted in the chamber, and thermal exchange is increased at these specific areas.

In an embodiment, the grooves have at least two different depths. Thereby, thermal exchange can be granularly controlled and thus be adapted to the thermal profile of the electronic components beneath the cold plate.

In the present specification, shoulders and constrictions are used interchangeably to denote elements that protrude into the grooves from above

In an embodiment, the slots are formed by grooves in the fins perpendicular to their extension. These may be milled out. By inserting constrictions into these grooves from above, flow is constricted in the chamber, and thermal exchange is increased at these specific areas.

In an aspect, the invention relates to a computing system comprising a computing device producing heat at two rates at two locations mutually spaced apart, the computing system further comprising a cold plate assembly (100) adapted to provide localised cooling to said two locations mutually spaced apart through its exterior surface, and the cold plate assembly has a slot layer with a slot architecture dimensioned in a manner that effects a non-uniform cooling over the cold plate exterior surface, where said non-uniform cooling matches the spacing and heat generation of said two locations mutually spaced apart.

In an aspect, the invention relates to a method of manufacturing a cold plate assembly comprising:
- providing a heatmap of a computing system comprising a computing device producing heat at two rates at two locations mutually spaced apart, the thermal map mapping the relative heat generation of said at least two electrical components as well as their relative locations,
- providing a template cold plate assembly design,
- modifying said template design by mutually adapting parameters relating to the inlet manifold, the inlet slots, the chamber, the fins, the outlet slots and the outlet manifold to achieve a cooling profile of the cold plate exterior surface that matches the thermal map of the computing system, and producing a cold plate assembly according to the modified template design.

Thereby, a specially adapted cold plate assembly is achieved that utilises the thermal capacity of the cooling liquid and pumping energy of the cooling system maximally. Furthermore, cooling is supplied to a primary heat source as well as high-power secondary heat sources, said cooling being precisely tailored to the layout of a specific computing part. Even furthermore, this is achieved within a parametric design space, where fins are located beneath openings that are in turn connected to an inlet manifold and an outlet manifold. Thus, the template design constrains the cold plate assembly sufficiently for a standard starting point to be made individually and modified in a user-friendly manner. This modification can then take the shape of selecting a fitting number and arrangement of inlet slots and outlet slots thus modifying their relative dimensions as well as any specific constrictions that should be present in the chamber itself to facilitate even better localised cooling.

Providing the specific heat map can be performed in a range of ways, such as by reviewing the computing device while performing certain computing tasks for a period of time with an infrared camera or a range of temperature sensors. Alternatively, it may be an assessment of the expected relative component load, or it may be provided by for example a computing device manufacturer.

Such heat map may describe a differentiated heat map of a newer generation CPU or GPU chip which may itself have a differentiated heat map. In an embodiment, the heat map is an extended heat map describing at least two different functional elements of the computing device, where each element is a functional element of a computing device, such as RAM and CPU or RAM and GPU.

In an embodiment, the template design is exposed to a simulation environment approximating the heat map of a specific computing unit, and certain production parameters are set. Then, a plurality of permutations of the template design are generated and evaluated against the simulation environment. Several generations of permutated designs may be produced and evaluated, at the end of which a fitting permutation is selected and manufactured.

By providing an assembly template with specific variations, which affect thermal profile over the surface of the cold plate outer surface, thermally optimised, easily machinable cold plate assemblies are achieved, whereas normally it is prohibitively expensive to design a thermally adapted cold plate assembly. The assembly template then comprises a parametrically constrained solution space with meaningful variations, and preparing this to a specific computing device geometry allows determination of an enumerable series of candidates for comparison. This is allowed at least in part because the inventor has identified key parameters to constrain and key parameters to allow to permutate. It only requires, from computing device to computing device, the heat map and preferably an attachment map of the specific device. By simply varying number, placement and geometry of inlet slots and outlet slots, the thermal profile is adapted very accurately. As mentioned, further adaptations can be made as well.

### BRIEF DESCRIPTION OF THE DRAWINGS

In the following, example embodiments are described according to the invention, where
Fig. 1 is an isometric view of an assembled cold plate assembly according to an embodiment of the invention, said cold plate assembly mounted on a computing device,
Fig. 2 is an exploded view of a cold plate assembly according to an embodiment of the invention,
Figs. 3A-3C show slot layers according to different embodiments of the invention,
Fig. 4 illustrates a cold plate and an slot layer according to an embodiment of the invention,
Fig. 5 illustrates a cold plate according to an embodiment of the invention,
Figs. 6A-6C illustrate different horizontal layouts of the slot layer according to embodiments of the invention,
Figs. 7A-7B illustrate a cold plate assembly constructionally and thermally adapted to a specific computing device according to an embodiment of the invention,
Fig. 8 is a cross-sectional side view of the cold plate assembly with thermal adaptation to a heatmap of a computing device, and
Fig. 9 is a manufacturing method of a cold plate assembly according to the invention.

### DETAILED DESCRIPTION

In the following, the invention is described in detail through embodiments thereof that should not be thought of as limiting to the scope of the invention.

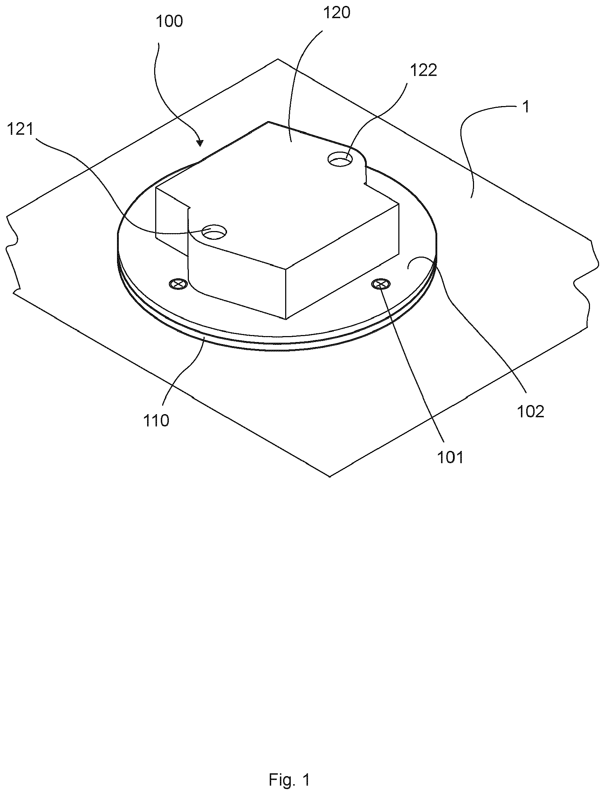

Fig. 1 is an isometric view of an assembled cold plate assembly 100 according to an embodiment of the invention, said cold plate assembly 100 mounted on a computing device 1. A cold plate 110 and a distribution block 120 are fastened conventionally to each other with screws 101 to ensure a tight fit and a reversible hold. Other types of fasteners can be used, and the screws, if used, can be fastened from below the cold plate instead of from above as shown.

Typically, the cold plate 110 is produced in a heat-conductive material, preferably copper, but aluminium or more exotic materials can also be used. The cold plate has fins (not shown) for improved thermal exchange.

The distribution block 120 has an inlet opening 121 for receiving cool liquid and an outlet opening 122 for dispensing warmed liquid.

Fastening the cold plate assembly against the computing device 1 may be performed by a conventional bracket fastening from above against the peripheral lip 102 of the cold plate assembly 100 or the top of the distribution block 120 (bracket not shown) and mounted to interfacing holes on a PCB of the computing device 1.

Alternatively, the cold plate assembly 100 may have an integrated mounting interface to make it easy to mount it onto the computing device 1 such as a CPU, or the cold plate assembly may have further mounting means to facilitate a secure hold such as using screws which may be useful when mounting the cold plate assembly on a processing card or a graphics card or such.

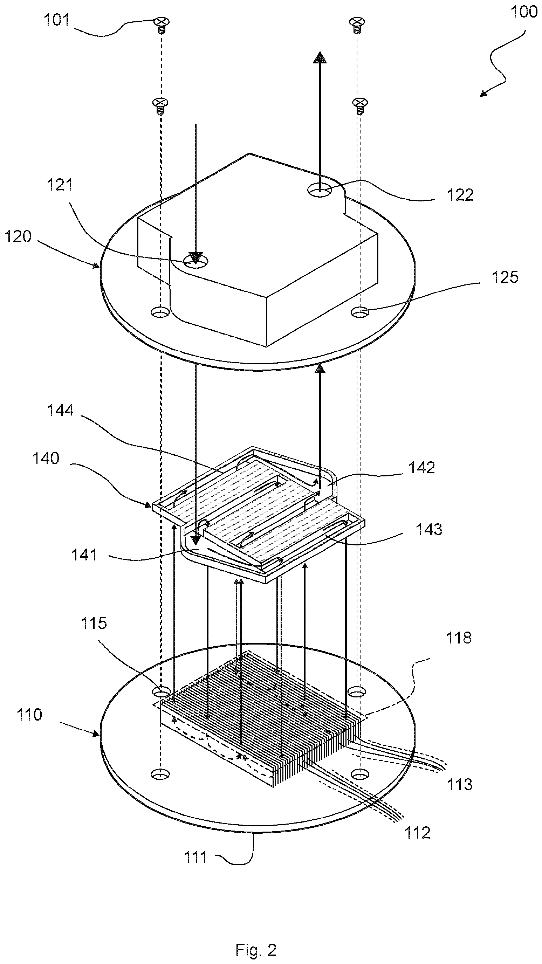

Fig. 2 is an exploded view of a cold plate assembly 100 according to an embodiment of the invention.

The cold plate assembly 100 has a distribution block 120 that interfaces with the cold plate 110 through block mounting means 125 using screws. Other fastening means can be used.

The cold plate assembly 110 further comprises a cold plate 110 which has fins 112, and among/between the fins 112, microchannels are formed. The cold plate has plate-mounting means 115 for interfacing with the block-mounting means of the distribution block to fasten the two parts securely.

When the cold plate 110 and the distribution block 120 are attached, a chamber is formed between them enveloping the fins.

The chamber further envelopes a slot layer 140 placed between the cold plate and the distribution block 120. The slot layer 140 has an inlet region and an outlet region each connected to inlet slots and outlet slots, respectively. However, the inlet region and outlet region are not in liquid communication in the slot layer. Instead, these regions are separate rooms. The inlet region is connected to the inlet 121, and the outlet region is connected to the outlet 122.

The inlet region 141 is connected to at least two inlet slots 143, each inlet slot 143 extending over the fins 112 at an angle to the extension of the fins 112 and thus providing liquid communication to the microchannels 113 among the fins 112.

The outlet region 142 is connected to at least two outlet slots 144, each outlet slot 144 extending over the fins 112 at an angle to the extension of the fins 112 and thus providing liquid communication to the microchannels 113 among the fins.

The slot layer 140 matches at least substantially in cross sectional area, as measured between the farthest sides of the outermost slots 143, 144, to the finned area 118 of the cold plate 110. The area marked to be the finned area 118 in Fig. 2 is slightly larger than the actual finned area shown, for ease of reading the figure, but it should be understood to correspond to the actual size. Further, the slot later 140 may extend slightly over the sides or be slightly smaller than the finned area, but it matches at least substantially.

Thereby, a novel approach to cold plate assemblies is achieved, where the cold plate 110 can be designed for mounting to the physical size and dimensions of the computing device, and a different part of the cold plate assembly 100, namely the distribution block 120 and in particular the slot layer 140, determines how the heat exchange is performed over the finned area 118 corresponding to the computing device beneath. Previously, such precise heat exchange has not been possible or easy to achieve.

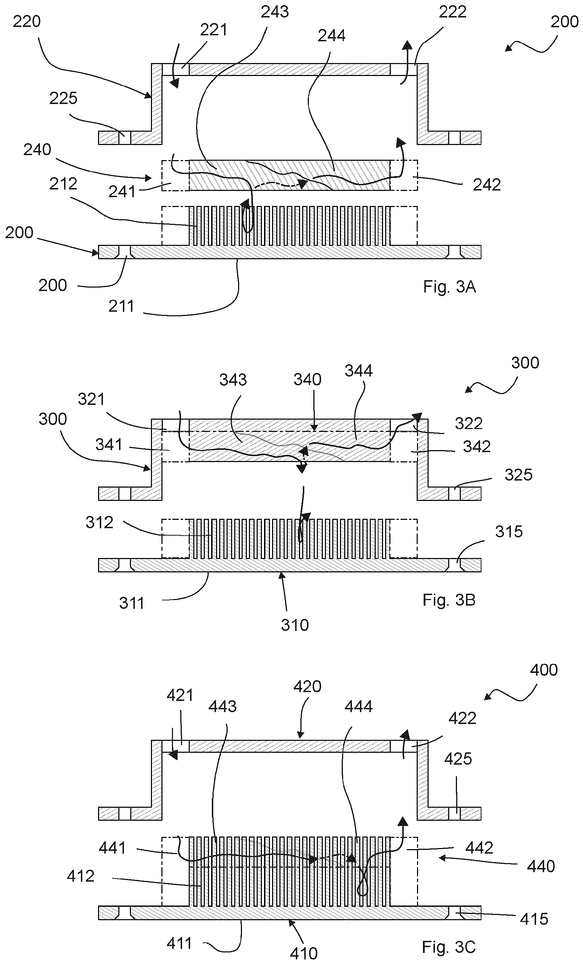

Figs. 3A-3C show slot layers according to different embodiments of the invention.

For all of Figs. 3A-3C, the liquid follows the same path through the cold plate assemblies 200, 300, 400, i.e. from the inlet in the distribution block to the inlet region in the slot layer and to the microchannels between the fins on the cold plate. Here, the liquid exchanges heat with the fins and the cold plate and is then dispensed to the outlet region of the slot layer and further to the outlet to be received by the liquid cooling system outside the cold plate assembly.

Fig. 3A is a cross-sectional side view of a cold plate assembly 200 with a cold plate 210, a distribution block 220 and a separate slot layer 240. The cold plate 210 has an exterior surface 211, plate mounting means 215 and fins 212. The distribution block 220 has an inlet and an outlet and block mounting means 225. The slot layer 240 has an inlet region 241 and an outlet region 242.

When the cold plate assembly 200 is assembled, the distribution block 220 abuts onto the slot layer 240 top, and the cold plate fins 212 abut onto the slot layer bottom.

Fig. 3B is a cross-sectional side view of a cold plate assembly 300 with a cold plate 310 and a distribution block 320 with an integrated slot layer 340. The cold plate 310 has an exterior surface 311, plate mounting means 315 and fins 312. The distribution block 320 has an inlet 321 and an outlet 322, block mounting means 325 and a slot layer 340 with an inlet region 341 and an outlet region 342.

When the distribution block is attached to the cold plate, the lower surface of the distribution block 320 being the bottom of the slot layer 340 abuts onto the cold plate fins 312.

By using a distribution block 320 having an integrated slot layer 340, a robust system is achieved with few risks of leaky regions or parts in the system, thus reducing reliance on gaskets or seals which are often the parts failing first in such systems. It may still be advantageous to use seals between the fins 312 and the slot layer lower surface 340.

The distribution block 320 having an integrated slot layer 340 may also be formed by joining, bonding or otherwise affixing two individually manufactured parts.

Fig. 3C is a cross-sectional side view of a cold plate assembly 400 with a cold plate 410, a distribution block 420 and a slot layer 440 integrated with the cold plate 410. The cold plate 410 has an exterior surface 411, plate mounting means 415 and fins 412 which extend into and form the slot layer 440, having an inlet region 441 and an outlet region 442. The distribution block 420 has an inlet and an outlet and block mounting means 425.

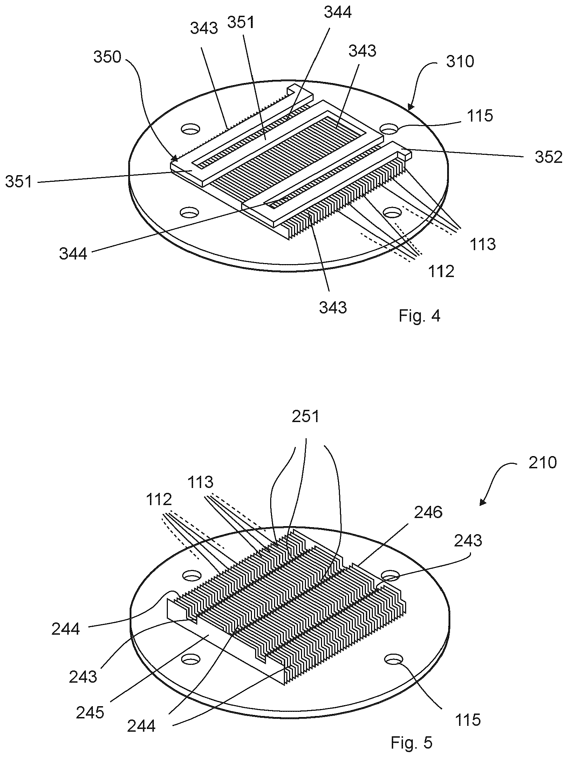

When the cold plate assembly 400 is assembled, the distribution block 420 abuts onto the slot layer 440 top which is formed from the fins 412. The slots (not shown) of the slot layer 440 are formed as groves perpendicular to the extension of the fins 412 and can be seen in more detail in Fig. 5.

By forming the slot layer integrally with the fins 412, an increased thermal exchange is achieved that also relies on fewer individual layers and as such relies less on seals/gaskets to prevent leaky regions. It may still be useful to use gasket parts or seals inside to improve the seal between the parts further, and a relatively simple rubber mat can be inserted between the roof of the distribution block 420 and the uppermost part of the fins 412 forming the slot layer 440.

Fig. 4 illustrates a cold plate 210 and an slot layer 240 according to an embodiment of the invention. This embodiment may remind the reader of the embodiment described in Fig. 3A. The cold plate has fins 212 and microchannels 213 between the fins 212.

The separate slot layer 240 is placed on top of the fins and has a serpentine body. The serpentine body comprises slot dividers 251 and first end parts 252 and second end parts 253. The slot layer 240 may be constructed at least partially from a pliable material conforming to the fins 212 beneath and a distribution block above.

The slot dividers 251 separate the chamber into slots 243, 244, while the end parts of the serpentine body 252, 253 ensure liquid communication between each slot and exactly one end, controlling which slots are inlet slots 243 and which are outlet slots 244. The serpentine shape of the slot layer 240 ensures that the slots are arranged alternatingly which is a preferable slot arrangement.

When a distribution block (not shown) is put over the fins 212 and the slot layer 240, an inlet region is formed in the end near the first end parts 252, and an outlet region is formed near the second end parts 253.

Liquid is thus moved into the inlet slots 243 while being blocked by the first end parts from moving directly into the outlet slots 244. Instead, the liquid moves to the microchannels, up to the outlet slots 244, and to the outlet region.

It should be noted that instead of being a separate part as thus described, the slot layer 240 may be formed integrally with the distribution block (not shown) or be otherwise affixed thereto. Such a variation may be considered a variation of the cold plate assembly of Fig. 3B.

Fig. 5 illustrates a cold plate according to an embodiment of the invention. It may remind the reader of the embodiment shown in Fig. 3C. The cold plate 410 has fins 412 and microchannels 413 between the fins. The cold plate has attachment means 415 for attaching to a distribution block (not shown). Furthermore, a slot layer 440 is formed into the fins through grooves 451.

The fins 412 have five recessed sections / grooves 451 serving as inlet slots 443 and outlet slots 444.

When a distribution block (not shown) is put over the fins 412 and forms a tight seal above the fins, an inlet region is formed near the first end 445, and an outlet region is formed near the second end 445.

Liquid passes from the inlet region in a first end 445, to the inlet slots 443, to the microchannels 413 between the fins 412, to outlet slots 444, to an outlet region, and out of the cold plate assembly at a second end 446. This controlled liquid pathing is controlled by a distribution block potentially in combination with a seal or gasket. The distribution block and/or adapter arrangement abuts onto the fins above, thus blocking liquid transport over the fins in non-recessed sections.

The grooves 451 can also be used to insert constrictions (not shown) to facilitate increased heat exchange at the constriction locations. This can be done in combination with using a groove 451 as a slot or instead of using the groove 451 as a slot.

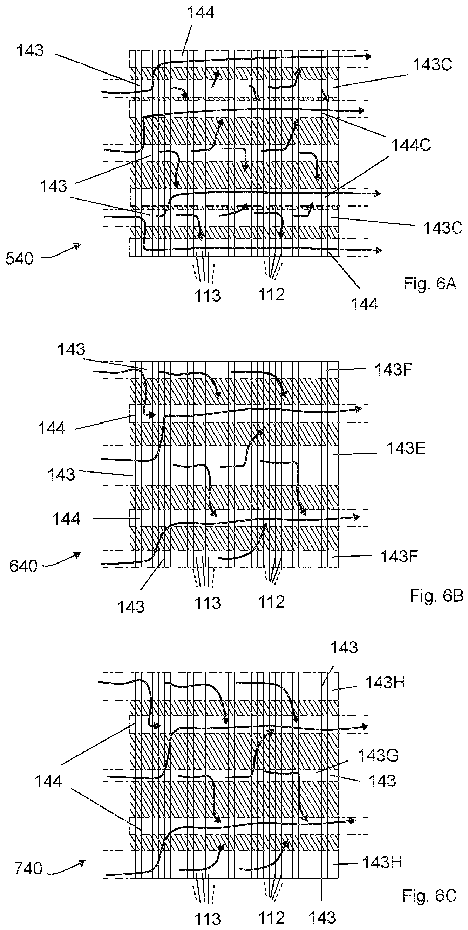

Figs. 6A-6C illustrate different horizontal layouts of the slot layer 140 according to embodiments of the invention. The horizontal layout of the slot layer is part of the slot architecture and determines a significant part of the thermal differentiation over the cold plate outer surface. For all of Figs. 6A-6C, the angled hatching does not indicate a fin angle but only parts of the slot layer 140 between neighboring slots.

Fig. 6A illustrates an embodiment slot layer 540 controlling flow in a chamber of the cold plate assembly. Three inlet slots 143 distribute liquid to the microchannels 113 between the fins 112, and four outlet slots 144 receive the liquid flow from the microchannels 113.

The shown slot layer 540 has a slot architecture adapted to a thermal profile of a computing device by mutual arrangement of the slots 143, 144. The innermost outlet slots 144C are placed nearer the periphery than an equidistant/similar arrangement would dictate, and they are thus almost adjacent the outermost inlet slots 146C.

The slots 143, 144 of the embodiment of Fig. 6A have identical individual geometries/size, and the adapted thermal profile is thus achieved through the slot arrangement alone.

Fig. 6B illustrates a different embodiment slot layer 640 controlling flow in a chamber of the cold plate assembly. Three inlet slots 143 distribute liquid to the microchannels 113 between the fins 112, and two outlet slots 144 receive the liquid flow from the microchannels 113.

The shown slot architecture is adapted to a thermal profile of a computing device by dissimilar relative inlet slot geometries 143. A central inlet slot 143E is wider than peripheral inlet slots 143F, thus facilitating a differentiated thermal profile over the cold plate outer surface.

The slots 143, 144 are arranged equidistantly as measured from the edges of each slot. In other words, the microchannel paths between each neighbour set of slots are identical. The flow resistance produced by the microchannel paths between each slot is thus identical, and the differentiated thermal profile results from the slot-relative geometries.

The shown slot layer 640 has a slot architecture adapted to a thermal profile of a computing device by dissimilar relative inlet slot geometries 143. A central inlet slot 143E is wider than peripheral inlet slots 143F, thus facilitating a differentiated thermal profile over the cold plate outer surface.

In another embodiment easily envisioned by the skilled person, the thermal profile is differentiated by dissimilar outlet slot 144 geometries instead of or in addition to inlet slot 143 geometries.

The central outlet slot 143E has two neighbouring outlet slots 144 which reduce the flow resistance through a flow path routing through the central inlet slot 143E markedly.

Fig. 6C illustrates an embodiment slot layer 740 controlling flow in a chamber of the cold plate assembly. Three inlet slots 143 distribute liquid to the microchannels 113 between the fins 112, and two outlet slots 144 receive the liquid flow from the microchannels 113.

The shown slot layers are adapted to a thermal profile of a computing device by dissimilar relative inlet slot geometries 143 and mutual arrangement of the slots 143, 144. A central inlet slot 143G is narrower than peripheral inlet slots 143H, while innermost flow paths from the central inlet slot 143G to outlet slots 144 are longer than peripheral flow paths from the peripheral inlet slots 143H to the outlet slots 144.

All of the aspects of the slot architecture discussed in relation to Figs. 6A-6C modify the relative flow, and the effects are further mutually dependent, meaning that changing one parameter, such as slot width, changes the influence of the other parameters, such as slot placement. Precisely controlling each of these traits in combination allows modifying the parameter, which has the greatest effect, and to a greater effect than each can achieve in isolation, thus achieving an optimised combination of relative flow among flow paths, pressure drop over the cold plate assembly and thermal efficiency in the microchannels.

For example, enlarging a central inlet slot may control relative thermal work between the central area. However, at a certain size, any further increase may serve mostly to create turbulent flow of tepid liquid in the centre of the inlet slot. On the other hand, where the distances between neighbouring slots need to be very different, certain flow paths will be very long or others will be very short. For very short paths, heat transfer efficiency drops because the cooling potential of the liquid is wasted. For very long paths, the thermal efficiency drops as the temperature difference between cooling liquid and the cold plate diminishes.

The skilled person will realise that the embodiments discussed in relation to Figs. 6A-6C are compatible in any manner with the embodiments discussed thus far, including embodiments relating to different ways of forming the slot layer.

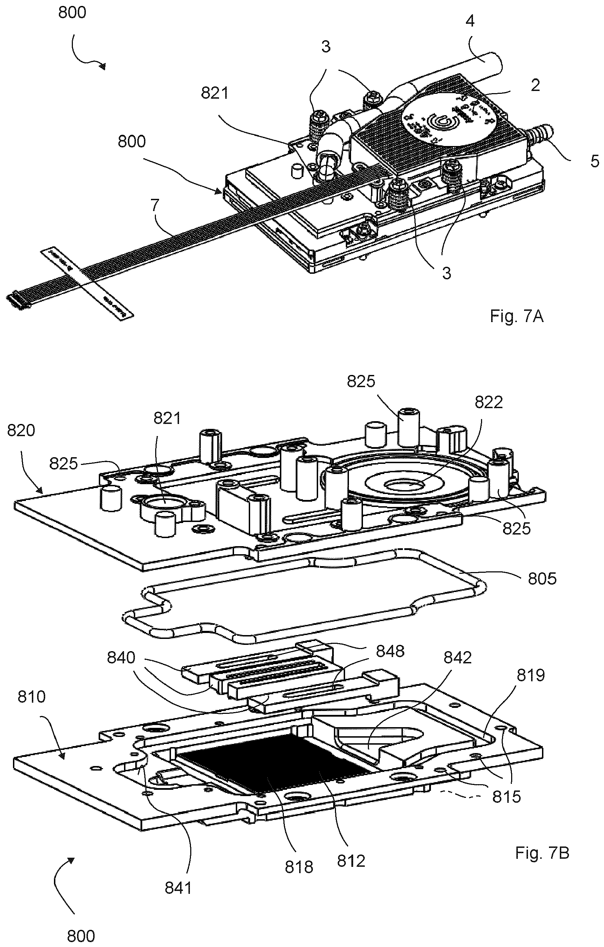

Figs. 7A-7B illustrate a cold plate assembly constructionally and thermally adapted to a specific computing device 1 according to an embodiment of the invention.

Fig. 7A illustrates a computing device 1 being an extension card such as a calculation card or a graphics card, said computing device 1 having an exemplary cold plate assembly 800 according to an embodiment of the invention. The cold plate assembly 800 conforms to the shape of the computing device 1. There is a computing interface cable 7. The computing device 1 has a given heatmap.

A pump 2 circulates cooling liquid in a cooling loop by drawing liquid through an inlet tube 4 into an inlet opening 821 through the cold plate assembly 800 to receive thermal energy from the extension card 1, and out of an outlet tube 5 to be cooled in another place, typically in a liquid-to-air-radiator or a liquid-to-liquid heat exchanger. The cold plate assembly 800 has the pump 2 mounted onto it and is in turn mounted to the computing device 1 by spring-loaded screws 3.

Fig. 7B is an exploded view of the cold plate assembly 800 of Fig. 7A. The cold plate assembly 800 comprises a cold plate 810 and a distribution block 820 which are mutually affixed by threaded engagement using fastening means 815, 825 and has an inlet opening 821 and an outlet opening 822. The distribution block 820 is attached to the cold plate 810 by a plurality of screws (not shown) to ensure a robust attachment.

The shape of the cold plate 810 exterior surface is adapted to the specific computing device. This is part of a constructional adaptation.

The cold plate 810 has a finned area 818, an inlet region 841 and an outlet region 842 on opposite sides of the finned area 818. The cold plate 810 has a seal recess channel 819 for receiving a peripheral seal 805. The fins 812 and the microchannels 813 run orthogonal to an axis that intersects the inlet 821 and the outlet 822.

Depending on the physical constraints of the computing device, the finned area 818, the inlet region 841 and the outlet region 842 are adapted to fit while optimising the layout to the heatmap of the computing device.

The slot layer 840 is formed substantially from a compressible seal material with channels 848 that mate frictionally with matching protrusions (not shown) on the underside of the distribution block 820.

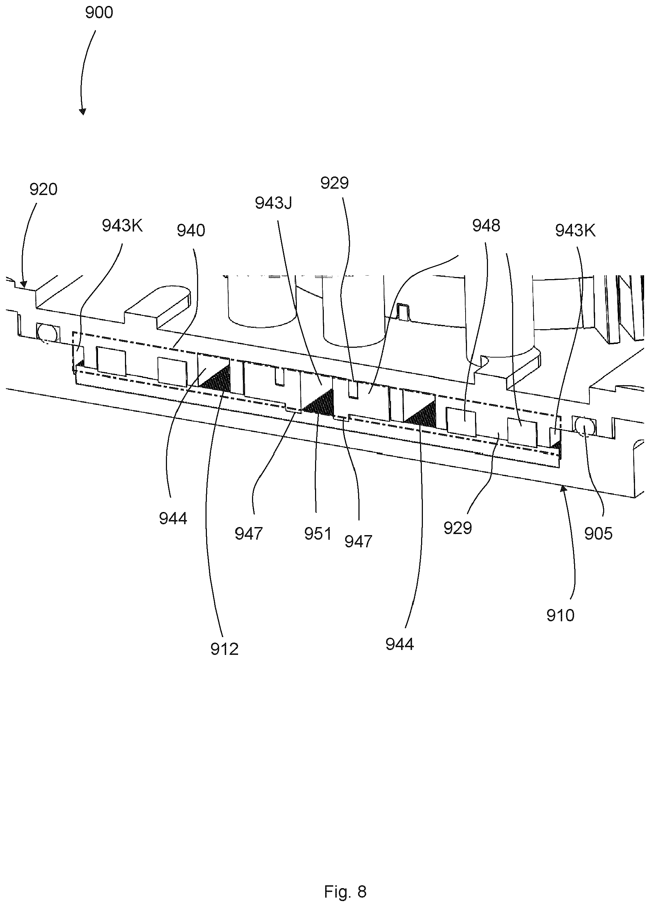

Fig. 8 is a cross-sectional side view of the cold plate assembly 900 with thermal adaptation to a heatmap of a computing device. A peripheral seal 905 between a cold plate 910 and a distribution block 920 are seen. A slot layer 940 is formed from an arrangement of seals 948 and matching protrusions from the distribution block 929.

The thermal profile of the cold plate assembly is adapted firstly by the distances between neighbouring slots 943, 944 being dissimilar. The peripheral inlet slots 943K are farther away from the outlet slots 944 than the distance between the central inlet slot 943J and the same outlet slots 944.

Secondly, the peripheral inlet slots 943K are narrower than the central inlet slot 943J which reduces the liquid travel through the peripheral inlet slots 943J further.

The cold plate assembly 900 has a slot layer 940, where these slots are located. As can be seen, for the most part, this slot layer extends slightly into the fins, except for directly under the central inlet slot 943J.

Directly under the central inlet slot and as part of this central inlet slot 943J, a groove 951 is cut into the fins. Firstly, this reduces the distance between the top of the fins 912 at the central inlet slot 943J and the bottom of the cold plate which reduces the flow resistance for the central inlet slot 943J compared to other inlet slots. Secondly however, constrictions 947 extend into the groove 951 producing a flow constriction which increases the flow resistance through the central inlet slot 943J while increasing heat exchange directly below these constrictions, where the flow is forced closer to the cold plate and likely at a higher speed.

The forming of grooves 951 as part of inlet slots and outlet slots and the use of constrictions in these grooves 951 make up the vertical layout of the slot layer and is a part of the slot architecture.

The embodiment of the cold plate assembly 900 discussed in relation to Fig. 8 is thus thermally adapted in many ways. The optimal combination of the discussed parameters making up the horizontal layout of the slot architecture and the vertical layout of the slot architecture can be difficult to find precisely for any given heat map.

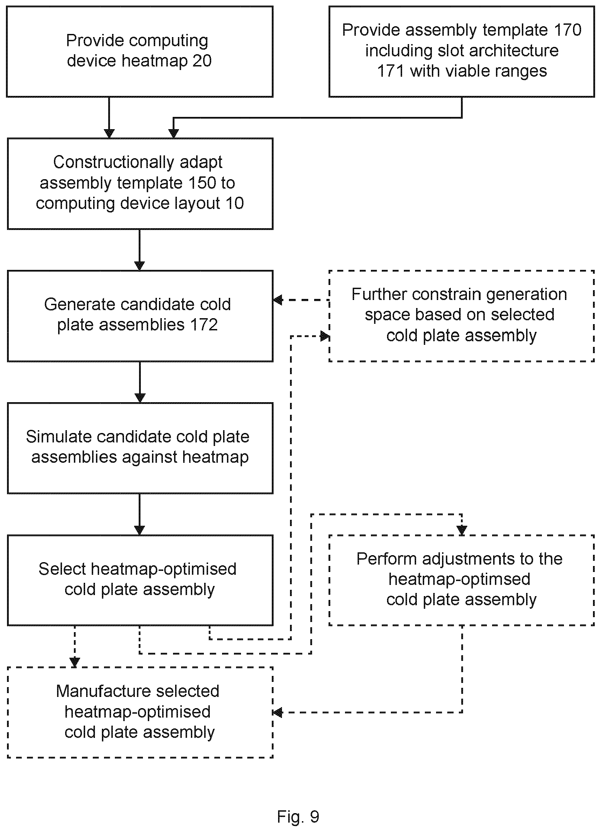

Fig. 9 illustrates a computer-assisted method of manufacturing a cold plate assembly according to an embodiment of the invention.

A heatmap 20 specific to a given computing device is provided, as is a cold plate assembly template 170 comprising a set of parameters that can be adjusted in specific ways to modify the liquid flow in the chamber of the cold plate assembly. The assembly template 170 is then constructionally adapted to the specific physical layout of the computing device having the provided heatmap 20. A series of different candidate cold plate assemblies are then generated. The candidate cold plate assemblies are then evaluated against the heatmap in thermal simulations and from among the candidates, a heatmap-optimised assembly is selected.

Once selected, three different paths are possible. Firstly, the selected heatmap-optimised candidate 172 cold plate assembly can be manufactured. Secondly, the selected heatmap-optimised candidate 172 can be adjusted before manufacture. Thirdly, an iterative simulation can be performed, where new candidates are generated based on the selected heatmap-optimised candidate. This iterative approach can be performed, until a certain thermal fit has been achieved.

In the following, the method will be described in more detail.

The heatmap 20 is provided for the computing device. The heat map describes the relative heat generation of different computing device components as well as their relative placement. The heatmap describes a differentiated heatmap and can describe a newer generation CPU or GPU which can be large and have a differentiated heat map itself. Otherwise, the heatmap has at least a specific computing device-functional element, such as RAM and CPU or RAM and GPU, and a general secondary heat source which can be indicated as a percentage of the functional element and a general direction relative thereto, or as a specific heat production at a specific place. The heatmap 20 can be provided by reviewing the computing device while performing certain computing tasks with an infrared camera, or a computing device manufacturer can provide a precise heatmap.

An assembly template 170 is provided. The assembly template 170 comprises a cold plate template with a cold plate finned area template having an adaptable location and size, an adaptable distribution block, attachment means between the cold plate and distribution block having adaptable placements as well as an adaptable slot architecture 171.

The adaptable slot architecture 171 relates to the slot layer and can be adapted by modifying a number of parameters:
- the number of inlet slots and outlet slots,
- the arrangement/placement of slots relative to each other,
- the width of slots relative to each other,
- how far down towards the cold plate the slots extend into the fins relative to each other, and
- use of constrictions into any grooves in the fins.

The slot architecture has at least two inlet slots and at least two outlet slots providing a flow path from an inlet, to an inlet region, to the at least two inlet slots, to all microchannels among the fins, to the at least two outlet slots to an outlet region, and to an outlet.

The assembly template may further provide a constrained solution space of allowable variations for the layout and dimensions of parts of the cold plate assembly. This can be provided by tooling increments and material constraints of a milling machine and milling vibration/power determining, for example, minimum fin width and fin width increments. Thereby, the adaptable parameters are not completely freely determined.

In addition to the heatmap, an attachment map of the computing device is preferably provided as well, describing attachment points, attachment types such as hole sizes, as well as clearances and parts heights. This is useful because the assembly template is constructionally adapted to the physical constraints and layout of the specific computing device. For example, the cold plate footprint adapts to the computing device and may extend over an entire computing card as is the case of the embodiments shown in Figs. 7A-7B and 8. Alternatively, the cold plate footprint may be limited to a given size as is the case for the embodiments shown in Figs 1-6. Another constructional adaptation is whether to accommodate different parts with the cold plate assembly, such as providing a pump housing with the cold plate assembly or not. In any regard, the assembly template is thus constructionally adapted to the computing device. This constructional adaptation is either performed by a technician or by software.

A prepared template is thus achieved by constructionally adapting the assembly template to the computing device. This ensures that any subsequent simulation is generated within all the bounds of the physical computing device as well as the manufacturing and tooling constraints.

A series of viable candidates are then generated, either by manually providing initial seed candidates, by randomly generating a set of candidates, or by generating a high variance pool of seed candidates.

The viable candidates vary from one another by having different slot architectures 171. Any slot architecture 171 covers a complete combination of slot dimensions and spacings in the horizontal and vertical layouts.

By constructing the cold plate assembly according to the invention using such method as described, it is possible to control the cold plate outer surface thermal work precisely among regions thereof and to accommodate several different computing devices with different heat maps using a common starting place, i.e. the assembly template.

Furthermore, depending on the relative arrangement and sizes of the different slots, the inlet manifold and outlet manifold may adapt dynamically as well within the constraints of the prepared template.

Vertical layout of the slot architecture comprises grooves and constrictions in the grooves.

Fin layout may also be adapted. By modifying the fin design, liquid flow and heat transfer in the chamber can be modified generally. Fins can also be machined with different widths and or spacing to promote different heat exchange rates orthogonally to the heat transfer differentiation possible with slot arrangement and sizing design. The inlet manifold and outlet manifold geometries and types may vary as well.

When candidate cold plate assemblies have been generated satisfactorily, they are exposed to a thermal simulation, where their ability to provide cooling over a simulated heat map is evaluated.

After such simulation, a heatmap-optimised cold plate assembly is selected, being a cold plate assembly, which provides cooling being dispersed over the heat map in a manner that matches the heat profile of the heat map.

The selected heatmap may be used to generate variations that are then tested in a simulated environment themselves. The method finds one or more suitable cold plate assemblies through iterative simulations, said one or more cold plate assemblies having an adapted cooling profile by modifying the limited set of parameters of the cold plate assembly.

Alternatively, using parameter increments results in an enumerable total solution space, and all variations can thus be simulated to find the most suitable solution.

When the heatmap-optimised cold plate assembly cooling profile has been found to be adequately effective, the heatmap-optimised cold plate assembly may then be manufactured. Alternatively, certain adjustments may be performed to the heatmap-optimised cold plate assembly, where small modifications may produce cost-effective benefits, such as in manufacturing. Certain distances, which vary slightly, may be streamlined to reduce need for tool heat change, or reduce setup time, or other such practical adjustments. After any such adjustments, the selected heatmap-optimised cold plate is then manufactured.

By providing an assembly template with a parametrically constrained solution space and a heat map, which the adaptable parameters can affect, a simulation environment can approximate an effective cooling solution and find an optimised assembly.

## Claims

1. A cold plate assembly for use in a liquid cooling system for cooling a computing device, said cold plate assembly comprising:
- a cold plate with an exterior surface (111) for facing the computing device to be cooled and an opposite inner surface with fins and microchannels between said fins,
- a distribution block fastened to said cold plate and together with said cold plate forming a chamber surrounding the fins between the distribution block and the inner surface of said cold plate, said distribution block comprising
- an inlet opening for receiving cooling liquid from said liquid cooling system, the inlet opening connected to at least two inlet slots extending over the fins and angled relative to the fins and for transporting liquid along said inlet slots and down towards said inner surface of said cold plate via said microchannels and
- an outlet opening for dispensing cooling liquid to said liquid cooling system, the outlet opening connected to at least two outlet slots extending over the fins and angled relative to the fins and for transporting liquid from said inner surface of said cold plate via said microchannels and along said outlet slots to said outlet opening.

2. A cold plate assembly according to claim 1, wherein said cold plate assembly has been specifically adapted to a predefined cooling profile of the computing device (1) by the distribution block (120) having a slot layer (140) with an adapted slot architecture, said slot architecture relating to the horizontal layout of the slots over the fins and the vertical layout of the slots facing towards the cold plate inner surface, where the adaptation comprises at least two inlet slots or two outlet slots having dissimilar geometries.

3. A cold plate assembly according to any of claims 1-2, wherein the distribution block comprises a slot layer (140) having a slot architecture describing the number of slots and relative size and arrangement of said slots and a vertical layout describing the relative slot depths facing towards the cold plate inner surface, where the cold plate assembly is adapted by the slot layer (140) having at least one of the following:
- at least two inlet slots with dissimilar widths (143E, 143F),
- at least two outlet slots with dissimilar widths,
- at least one slot whose neighbouring slots are spaced therefrom dissimilarly (144C), measured as the span between adjacent slot edges, and
- a slot comprising a recessed groove (251) in the fins, the fin height beneath said slot being lower than the fin height beneath another slot.

4. A cold plate assembly according to any of claims 1-3 having at least two inlet slots with dissimilar widths (143E, 143F).

5. A cold plate assembly according to any of claims 1-4 having at least two outlet slots with dissimilar widths.

6. A cold plate assembly according to any of claims 1-5 having at least one slot (144C) whose neighbouring slots are spaced therefrom dissimilarly, measured as the span between adjacent slot edges.

7. A cold plate assembly according to any of claims 1-6 having a slot comprising a recessed groove (251, 951) in the fins, the fin height beneath said slot (943J) being lower than the fin height beneath another slot (943K).

8. A cold plate assembly according to any of claims 1-7 comprising a separate slot layer (140) sandwiched between the cold plate (110) and the housing block (120), said separate slot layer (140) separating inlet slots (143) from outlet slots (144).

9. A cold plate assembly according to any of claims 1-8, wherein the cold plate assembly comprises a slot layer (140) having an elastic seal component deformed and complying with the dimensions of the cold plate (110) and the distribution block (120).

10. A cold plate assembly according to any of claims 1-9 having a slot layer (140), where the slot layer (140) has an inlet region (141) and an outlet region (142) and the inlet slots (143) and the outlet slots (144), and where the inlet slots (143) and outlet slots (144) interdigitate with each other at an angle relative to the fins, preferably orthogonally, whereby the inlet region forms a dividing I-type manifold structure and the outlet region forms a collecting I-type manifold.

11. A cold plate assembly according to any of claims 1-10, wherein the path going from the inlet region to inlet slots to the microchannels to the outlet slots and to the outlet region forms a Z-type manifold structure.

12. A cold plate assembly (100) according to any of claims 1-11, wherein the inlet slots (143) and outlet slots (144) are elongate in a direction orthogonal to the extension of the fins (112), and where said inlet slots (143) interdigitate with said outlet slots (144).

13. A computing system comprising a computing device producing heat at two rates at two locations mutually spaced apart, the computing system further comprising a cold plate assembly (100) adapted to provide localised cooling through its exterior surface to said two locations mutually spaced apart, and
- the cold plate assembly having a slot layer with a slot architecture dimensioned in a manner that effects a non-uniform cooling over the cold plate exterior surface, where
- said non-uniform cooling matches the spacing and heat generation of said two locations mutually spaced apart.

14. A method comprising:
- providing a heatmap of a computing system with at least two different electrical components mutually spaced apart and having two different heat generation rates, the thermal map mapping the relative heat generation of said at least two electrical components as well as their relative locations,
- providing a template cold plate assembly design,
- modifying said template design by mutually adapting parameters relating to the inlet manifold, the inlet slots, the chamber, the fins, the outlet slots and the outlet manifold to achieve a cooling profile of the cold plate exterior surface that matches the thermal map of the computing system, and
- producing a cold plate assembly according to the modified template design.
